Europäisches Patentamt

European Patent Office

Office européen des brevets

(19)

(11) Publication number: **0 294 991**

**A2**

(12) # EUROPEAN PATENT APPLICATION

(21) Application number: 88304965.2

(22) Date of filing: 01.06.88

(51) Int. Cl.4: **C01B 13/18 , C01G 33/00 , C04B 35/00**

(30) Priority: 10.06.87 JP 143355/87
24.06.87 JP 155348/87
10.02.88 JP 27792/87
10.02.88 JP 27793/87

(43) Date of publication of application:
**14.12.88 Bulletin 88/50**

(84) Designated Contracting States:
**BE DE FR GB NL**

(71) Applicant: **NIPPON STEEL CORPORATION**
**6-3 Otemachi 2-chome Chiyoda-ku**
**Tokyo 100(JP)**

(72) Inventor: **Suyama, Ryuji c/o R&D**
**Laboratories-1**
**Nippon Steel Corporation 1618, Ida**
**Nakahara-ku**
**Kawasaki-shi Kanagawa(JP)**
Inventor: **Tanemoto, Kei c/o R&D**
**Laboratories-1**
**Nippon Steel Corporation 1618, Ida**
**Nakahara-ku**
**Kawasaki-shi Kanagawa(JP)**
Inventor: **Kubo, Hiroshi c/o R&D**
**Laboratories-1**
**Nippon Steel Corporation 1618, Ida**
**Nakahara-ku**
**Kawasaki-shi Kanagawa(JP)**

(74) Representative: **Arthur, Bryan Edward et al**
**Withers & Rogers 4 Dyer's Buildings Holborn**
**London EC1N 2JT(GB)**

(54) **Readily sinterable powder of perovskite type oxide containing group Va element and laminated element obtained therefrom.**

(57) A method of synthesizing piezoelectric-electrostrictive and dielectric ceramics powder, which comprises mixing an aqueous oxalate solution of a group Va element of the periodic table, a solution containing at least one ion selected from the group consisting of ions of Pb, Bi, Ba, Sr, Ca, and rare earth elements (hereinafter "A" element) and a solution containing at least one ion selected from the group consisting of ions of Mg, Cr, Mn, Fe, Co, Ni, Cu, Zn, Ti, Zr, and Hf (hereinafter "B" element) with an alcohol to form precipitates of oxalates of "A" and "B" elements, adjusting a pH of the solution to 3 or more to form hydroxides of the group Va element of the periodic table in the oxalate precipitates, and mixing, filtering, washing, drying, and pyrolyzing the mixture comprising the oxalates of "A" and "B" elements and hydroxides of the group Va element of the periodic table, whereby a perovskite type oxide containing the group Va element is synthesized and multilayer elments, multilayer electrostrictive actuators and multilayer ceramic capacitors derived from the above-mentioned readily sinterable $Pb(Mg_{1/3}Nb_{2/3})O_3$-based oxide powder are also provided.

EP 0 294 991 A2

*Fig. 6*

# READILY SINTERABLE POWDER OF PEROVSKITE TYPE OXIDE CONTAINING GROUP Va ELEMENT AND LAMINATED ELEMENT OBTAINED THEREFROM

## BACKGROUND OF THE INVENTION

### 1. Field of the Invention

The present invention relates to a method of synthesizing a readily sinterable piezoelectric-electrostrictive and dielectric ceramic powder of perovskite type oxides containing a group Va element. The perovskite type oxide containing a group Va element itself or a solid solution of two or more of the same are widely used in electronic parts as a dielectric material or piezoelectric-electroconstrictive material. Especially, Pb$(Mg_{1/3} Nb_{2/3}) O_3$ (hereinafter PMN) has a high utilization value as a dielectric material and an electroconstrictive material.

The present invention also relates to a multilayer electrostrictive actuator utilized as a driving element for a precise positioning device and a multilayer ceramic capacitor widely utilized as an electronic part, derived from the readily sinterable PMN oxide powder.

### 2. Description of the Related Art

As the method of synthesizing perovskite type oxide powder containing the group Va element, there are known:

(1) the method of mixing oxide powders of the component elements and reacting calcining the mixture in a solid phase at a high temperature;

(2) the method of forming co-precipitates of the component element ions from the solutions containing the same and drying, calcining, and pyrolyzing the co-precipitates.

The methods of forming the precipitates according to method (2) include the following:

(2-A) the alkoxide method, in which alkoxides of the component ions are co-precipitated by hydrolysis;

(2-B) the method in which hydroxides are co-precipitated by adjusting the pH of the aqueous solution to a certain value or higher;

(2-C) the method in which an alcoholic solution of oxalic acid is added to the aqueous solution to co-precipitate oxalates.

However, the powder obtained by the solid phase reaction of (1) generally is in the form of coarse particles, can be sintered only with great difficulty, and a high temperature or an addition of a sintering accelerator is required for sintering.

Particularly, as in the case of PMN, because not only the desired perovskite phase but also the pyrochroite phase, which remarkably impairs the material characteristics, is formed by mixing and calcining PbO, MgO, $Nb_2O_5$ , it is usual to obtain the perovskite phase of $Pb(Mg_{1/3}Nb_{2/3})O_3$ by first mixing and calcining MgO and $Nb_2O_5$ to synthesize a compound of $MgNb_2O_6$ , and again calcining this compound with an addition of PbO (S. L. Swartz et al, Mat. Res. Bull. 17, 1245), but this causes grave problems in that the operation is cumbersome and that, since a calcination temperature is high, a synthesis of a fine powder having a good sinterability becomes more difficult.

When the above-mentioned coarse powder having a poor sinterability is utilized, various disadvantages appear. Especially, when PMN perovskite type oxide powder is utilized as a multilayer electrostrictive actuator or a multilayer ceramic capacitor, the following serious problems arise. That is, the greatest problem when utilizing such a coarse powder in a laminated electrostrictive actuator element is a displacement of the hysteresis. The term hysteresis means that the magnitude of displacement at a certain voltage is different at the time when the voltage is increased and at the time when it is decreased, and when this difference is marked, it becomes extremely difficult to control the actuator only by a change in applying voltage.

Recently, as the material for an actuator, electrostrictive materials have been utilized in place of the piezoelectric materials.

Since the strain generation mechanism of an electroconstrictive material is different from that of a piezoelectric material, the hysteresis thereof is known to be extremely small, in principle, and PMN is regarded as the most suitable material for an actuator, because it exhibits much the same amount of displacement as a piezoelectric material.

Furthermore, in multilayer ceramic capacitors, the use of perovskite type composite oxides containing lead having a larger dielectric constant has been studied, to replace the barium titanate ($BaTiO_3$), widely used as a dielectric material in the prior art. Of these compounds, PMN is known to have a large dielectric constant of up to 18000 and, therefore, is considered useful for realizing a small-sized capacitor having a large capacity (see JP-B-61-28619).

As mentioned above, PMN has extremely suitable characteristics as the material for an actuator or a capacitor and has a wide range of applications, but the displacement characteristics of the multilayer electrostrictive actuator, especially the hysteresis, depend greatly on not only the characteristics of the material but also the particle size of the sintered product. That is, it is known in the art that the hysteresis becomes larger, and therefore the controllability becomes worse, as the particle size becomes larger and less-uniform. On the other hand, in a multilayer ceramic capacitor, the thickness of each layer is decreased, to increase the capacitance, but the use of the above-mentioned coarse and non-uniform powder makes it difficult to form a layer having a uniform thickness, and thus the thickness of the layer cannot be made thinner.

In addition to the above, when multilayer elements (e.g., multilayer electrostrictive actuators and multilayer ceramic capacitors are produced by using the above-mentioned difficult-to-sinter powder, other problems arise. That is, multilayer elements have a structure using ceramic materials and electrodes for applying a voltage thereto (generally called internal electrode) which are alternately laminated, but if the ceramics and the electrodes are laminated alternately, enormous labor is required the precision is such that of the device is useless in practice. Therefore, ignoring such a method, the device is produced according to the method in which the powder is previously formed into sheets, the sheets are coated with electrode materials dispersed in an organic solvent, and tens of the sheets are laminated and sintered.

When a multilayer element is produced by this method of using a powder requiring a high temperature of 1200°C for sintering, as described above, the metal material used for the electrode is exposed to a high temperature during sintering, is oxidized because it is sandwiched between the oxide powder, and in an extreme case is melted, and therefore, a novel metal having a high melting point and not easily oxidized even at a high temperature, such as Pt or Pd, is used as the metal material for the electrode, but these metals are very expensive and greatly hinder any attempt to lower the production cost of the multilyer elements.

As described above, since only a powder with a poor sinterability and a large particle size can be synthesized according to the solid phase reaction (1), attempts to obtain a precise element and to reduce the size and cost thereof are limited when multilayer elements are produced by using such a powder. For this reason, the co-precipitation method (2) has been used as a method of synthesizing fine powder having a good sinterability. Since in the co-precipitation method (2) the desired compound can be synthesized at a relatively lower calcination temperature, a fine powder having good sinterability can be obtained; but each method has the following drawbacks.

In the alkoxide method (2-A), a product having a high purity and high uniformity can be obtained, but since the respective component ions must be once synthesized as alkoxides, the preparation method becomes cumbersome and economically disadvantageous.

In the hydroxide co-precipitation method (2-B), since elements exist which cannot be completely precipitated even when the pH is made extremely high, typical of alkaline earth metals such as Mg, Sr, Ba, it is difficult to co-precipitate two or more kinds of elements at a desired ratio.

In the oxalate method (2-C), especially the method using an alcohol as a solvent, which utilizes the substantial insolubility of metal oxalate in alcohol, precipitates of a desired composition ratio can be relatively easily prepared, but because the solvent is an alcohol, an agglomeration of the particles can be prevented to give a powder having a good dispersibility (Japanese Examined Patent Publication (KOKOKU) No. 62-84), but this method has a serious drawback in that it is not applicable to a production of the perovskite type oxide containing the group Va element of the periodic table, because oxalate of the group Va element of the periodic table, which are important to the dielectric materials and piezoelectric-electrostrictive materials, are soluble in alcohol. Therefore, there is no known co-precipitation method of producing the perovskite type oxide containing the group Va element of the periodic table such as PMN, because the co-precipitation method has drawbacks in that the process operation is cumbersome, and some materials cannot be produced due to a non-appearance of precipitates.

3

SUMMARY OF THE INVENTION

Accordingly, the objects of the present invention are to eliminate the above-mentioned drawbacks of the prior art and to provide a method of synthesizing a perovskite type oxide powder containing the group Va element of the periodic table.

Another object of the present invention is to provide a readily sinterable powder capable of being sintered at a low temperature of $800°C$ to $1000°C$, for a PMN perovskite type oxide, and a synthesis method thereof.

A further object of the present invention is to provide multilayer elements having a high performance and a low cost produced from the above-mentioned PMN perovskite type oxide.

Other objects and advantages of the present invention will be apparent from the following description.

In accordance with the present invention, there is provided a method of synthesizing a readily sinterable powder of a perovskite type oxide containing a group Va element of the periodic table and, in the case of PMN, a multilayer element and a production process thereof, obtained by sintering the readily sinterable powder of a perovskite type oxide containing the same as a main component, at a temperature of $800°C$ to $1000°C$, which is lower by $200°C$ to $400°C$ than that of the prior art. One or both of $PbTiO_3$ and $Ba(Zn_{1/3}Nb_{2/3})O_3$ may be added to the PMN in an amount of 5 to 50%. $PbTiO_3$ is added to shift the Curie point of PMN, the displacement amount of the electrostrictive material, is increased while maintaining a small hysteresis, and the dielectric constant of the dielectric material is increased. Furthermore, $Ba(Zn_{1/3}Nb_{2/3})O_3$ is added for increasing the temperature stability of the characteristics. If the amount of the each additive added is less than 5% the intended effect is not obtained, and an amount of more than 50% results in a decrease in the inherent characteristics of the PMN.

In accordance with the present invention, the above-mentioned powder is produced by mixing an aqueous oxalate solution of a group Va element of the periodic table, a solution containing at least one ion selected from the group consisting of ions of Pb, Bi, Ba, Sr, Ca, and rare earth elements (hereinafter "A" element) and a solution containing at least one ion selected from the group consisting of ions of Mg, Cr, Mn, Fe, Co, Ni, Cu, Zn, Ti, Zr, and Hf (hereinafter "B" element) with an alcohol to form precipitates of oxalates of "A" and "B" elements, adjusting a pH of said solution to 3 or more to form hydroxides of the group Va element of the periodic table in said oxalate precipitates, and mixing, filtering, washing, drying, and pyrolyzing the mixture comprising said oxalates of "A" and "B" elements and hydroxides of the group Va element of the periodic table, whereby a perovskite type oxide powder containing the group Va element is synthesized.

In this method, the perovskite type oxide powder containing a group Va element can be produced in the same way by adding only oxalic acid to the alcohol, in place of the aqueous oxalate solution of a group Va element of the periodic table, and after adjusting the pH of the resultant solution to 3 or more, adding the aqueous oxalate solution of a group Va element of the periodic table.

Furthermore, when a perovskite type oxide powder comprising $Pb(Mg_{1/3}Nb_{2/3})O_3$, or the composite perovskite type oxide powder comprising $Pb(Mg_{1/3}Nb_{2/3})O_3$, as a main component, and one or both of $PbTiO_3$ and $Ba(Zn_{1/3}Nb_{2/3})O_3$ is synthesized according to the above-mentioned method, Nb is selected as a group Va element of the periodic table, Pb or Pb and Ba is selected as the "A" element, and Mg or Mg and Ti, Zn is selected as the "B" element.

As the method of production of the above-mentioned multilayer element, there is provided a method for producing the multilayer element by first forming the PMN powder into a sheet characterized by comprising a single phase perovskite containing particles having a substantially spherical shape and an average particle size, a standard deviation of both being 1 μm or less, or a powder containing PMN, as a main component, and 5 to 50% of one or both of $PbTiO_3$ and $Ba(Zn_{2/3}Nb_{1/3})O_3$, and then printing an electrode material such as Ag or conventionally used Pd on each ceramic sheet, then laminating 10 to 100 sheets, and finally sintering at a temperature of $800°C$ to $1000°C$ under an atmosphere of PbO.

BRIEF DESCRIPTION OF THE DRAWINGS

The present invention will be better understood from the description set forth below with reference to the accompanying drawings wherein:

Figure 1 is a flow chart showing $Ba(Zn_{1/3}Ta_{2/3})O_3$ synthesized in the present invention;

Figs. 2 and 3 are flow charts showing $Pb(Mg_{1/3}Nb_{2/3})O_3$ synthesized according to the present invention;

4

Fig. 4 is a drawing showing a particle size distribution of a PMN starting powder according to the present invention;

Fig. 5 is a photograph showing a powder particle structure of the PMN starting powder according to the present invention; and

Fig. 6 is a graph showing a comparison of displacement characteristics of the multilayer electrostrictive actuator produced by a $0.45Pb(Mg_{1/3}Nb_{2/3})O_3 - 0.36PbTiO_3 - 0.19Ba(Zn_{1/3}Nb_{2/3})O_3$ powder according to the present method and the prior art method.

## DESCRIPTION OF THE PREFERRED EMBODIMENTS

The present invention will now be explained in detail.

First an aqueous oxalate solution of the group Va element of a known concentration (solution 1), a solution containing A ions and B ions in amounts corresponding to the amount of the group Va element ions contained in the solution 1 (solution 2), and alcohol are prepared. As the solution 2, for example, aqueous solutions of nitrates, oxynitrates, and chlorides, etc., may be employed.

Next, while the alcohol is stirred, the solution 1 and the solution 2 are added dropwise to form oxalates of A and B elements. The dropping rate may be preferably 1 ml to 100 ml per minute, and stirring is performed to make the precipitates homogeneous. Subsequently, ammonia water is added to the solution at the same dropping rate to adjust the pH to 3 or higher or 12 or lower, desirably 5 or higher and 9 or lower, to form hydroxides of the Va group, which are added to the above oxalate precipitates, while stirring is continuously performed. If the pH is lower than the above range, the Va group metal will remain in the solution, and conversely, if it is too high, it will take a long time to wash away the excess ammonia water.

Also, other alkalis such as sodium hydroxide can be used in place of the ammonia water, but since ammonia reacts with excess oxalic acid to form ammonium oxalate, which inhibits the particle growth during calcination in the later stage, ammonia water is most preferred.

In the above-mentioned process, the perovskite type oxide powder containing a group Va element can be synthesized in the same manner by previously adding oxalic acid to the alcohol in an amount sufficient to precipitate "A" ions and "B" ions, followed by adding an aqueous oxalate solution of a group Va element of the periodic table after adjusting the pH of the solution to 3 or more, or by mixing an oxalate of "A" and "B" ions separately prepared and the hydroxide of a Va group element ion.

In all of the processes as described above, the amount of the alcohol is 50% or more by volume relative to the total amount of the solvent. This is because particles may be agglomerated if too much water is added.

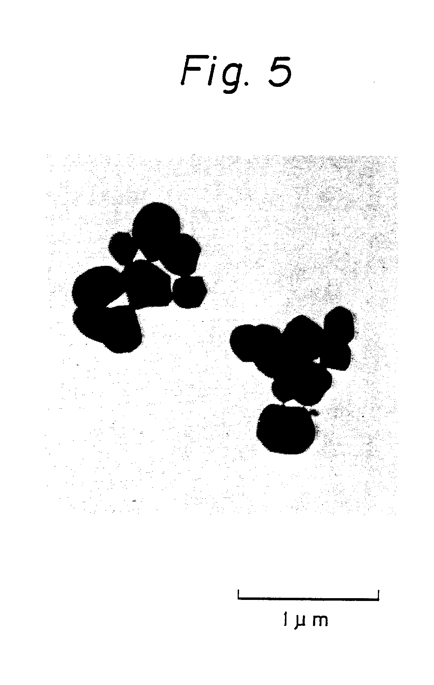

The precipitates thus synthesized are filtered and washed with alcohol, and after this operation is repeated 3 to 10 times, the product is thoroughly dried at $100°C$ to $200°C$, then ground and then calcined at a temperature of $700°C$ to $1000°C$, to be converted to a perovskite type oxide powder. The PMN powder obtained according to the above-mentioned method is shown in Fig. 5.

The laminated element according to the present invention is produced by using the PMN perovskite type oxide powder synthesized by the above-mentioned method, as follows.

It is common knowledge to those skilled in the art that, in order to obtain a sintered product having an extremely high bulk density even when the sintering temperature is decreased, the particles must have a substantial spherical shape, a particle size in the submicrons, and a very sharp particle distribution (e.g., both an average particle size and standard deviation of the practice size are 1 μm or less determined according to a centrifugal sedimentation method) are desirable, but no method of producing such a PMN powder in known in the prior art. There has been no attempt to sinter PMN at a temperature of $1000°C$ or less, and accordingly, the present inventors have studied a method of synthesising a PMN fine powder, and as a result, found that such a PMN powder can be produced by the above-mentioned method. Furthermore, when such a PMN powder having a uniform porosity and properties is used, the sintering temperature can be reduced to $200°C$ to $400°C$.

As long as the powder having a shape close to a spherical shape, a particle size in the submicrons, and a very sharp particle size distribution is used as the PMN starting material, the low temperature sintering as mentioned above is possible even though the powder is produced by another production method. The optimum method for producing such a PMN starting powder is the above-mentioned method of synthesizing the perovskite type oxide powder.

The multilayer element can be produced by the following conventional method.

First, the synthesized powder is mixed with an organic binder such as polyvinyl alcohol or polyvinyl butyral and an organic solvent such as acetone or ether to form a slurry and the resultant slurry is formed into sheets by using, for example, a doctor blade device, followed by drying the solvent. Namely, the powder is formed into sheets by the organic binder (Hereinafter, sheet forming process). The resultant sheets are cut into an appropriate size and an electrode material dispersed in an organic solvent is coated or screen printed thereon. The sheets thus obtained are laminated to form a laminated body, and thereafter, the laminated product is sintered to obtain a multilayer elements. Nevertheless, the resultant laminated body must be heated at a temperature of, for example, 400°C to 600°C for, for example, 5 to 20 hours, to decompose and separate unnecessary substances such as the organic binder, before sintering.

When the PMN type oxide powder according to the present invention is used, the element can be satisfactorily produced at a decreased temperature of 800°C to 1000°C, compared with the sintering temperature in the conventional process of producing the multilayer element of 1200°C. The preferable sintering conditions according to the present invention are a temperature of 800 C to 1000°C for a time of 10 minutes to 48 hours, more preferably 850°C to 900°C for 10 minutes to 8 hours. When the sintering temperature is lower than 800°C, the desired sintering does not occur, and when the sintering temperature is higher than 1000°C, the particle size of the sintered product becomes unpreferably large and an internal electrode material having a low cost cannot be used. Furthermore, to prevent a vaporization of PbO during sintering, the sintering vessel may have a double structure, wherein the sample is placed in the inner vessel and the PbO powder is sealed in the outer vessel, and thus, a PbO atmosphere is maintained within the outer vessel. Note, if the PbO is vaporized, variations of the composition occur and the inherent characteristics of PMN are lost.

According to the present invention, the following characteristics can be obtained.

(1) Since the A and B ions and the group Va element of the periodic table are mixed uniformly at the molecular level in the precipitates, and most of the precipitates have a perovskite phase composition, an almost pure perovskite phase can be obtained by one heat treatment at relatively low temperature.

(2) Since the A and B ions are oxalates, and the group Va ions are hydroxides, the formation of a different phase comprising only the A or the B ions and the group Va, such as a pyrochlore phase, can be inhibited, to readily produce a single phase perovskite phase.

(3) Since ammonia added during the process reacts with excess oxalic acid to form ammonium oxalate between the particles, which inhibits abnormal growth of the particles by a mutual agglomeration of the particles during the heat treatment, a starting powder having a small and regular particle size can be obtained.

(4) Since an alcohol with a lower surface tension than water is used, particles will rarely stick to each other during the process, giving a good dispersibility.

(5) Since readily available nitrates and oxalic acid are used as the starting materials, synthesis is possible by a relatively simpler process.

For the reasons mentioned above, the desired fine perovskite type oxide powder containing a group Va element of the periodic table and having a high uniformity can be readily synthesized, and as a result, since the powder may be sintered at a temperature lower than the conventional sintering temperature, the grain growth of the sintered product is small and, therefore, the characteristics of the electronic ceramics produced from this powder can be improved. This is generally true for perovskite type oxides containing any group Va element of the periodic table, but the effects are particularly remarkable in an PMN type oxide powder. Accordingly, the hysteresis is small in the electrostrictive actuator, and each ceramic layer of the laminated layer in the ceramic multilayer capacitor, can be made thin (e.g., a small sized capacitor with a large capacitance can be obtained). In addition, since the sintering can be carried out at a low temperature, a low cost internal electrode material can be used.

As mentioned above and explained below, according to the present invention, a fine and uniform perovskite type oxide powder containing a group Va element of the periodic table can be synthesized. Especially, in the PMN powder, the above-mentioned effects obtained according to the present invention are remarkable and the multilayer elements can be produced by sintering at a temperature of 800°C to 1000°C. As a result, the displacement hysteresis in the multilayer electro strictive actuator can be reduced by a half or more and a small sized multilayer ceramic capacitor having a high capacitance can be produced. In addition, since the sintering can be carried out at a low temperature, the electrode materials can be produced at a low cost and, therefore, the production cost of the element can be remarkably reduced. As a result, the range of applications of the multilayer electrostrictive actuator and the multilayer ceramic capacitor is widened and, therefore, a great effect is obtained by the present invention.

6

Examples

The present invention will now be further illustrated by, but is by no means limited to, the following Examples, wherein all parts and percentages are expressed on a weight basis unless otherwise noted.

Example 1

As a dielectric material for a microwave resonator, a compound represented by the general formula is $Ba(B_{1/3}B'_{2/3})O_3$ , wherein B represents Zn or Mg and B' is Nb or Ta, was used.

Three compounds, $Ba(Zn_{1/3}Nb_{2/3})O_3$ , $Ba(Zn_{1/3}Ta_{2/3})O_3$ , and $Ba(Mg_{1/3}Ta_{2/3})O_3$ were synthesized as follows.

For example, in the case of $Ba(Zn_{1/3}Ta_{2/3})O_3$ , a 100 ml amount of aqueous tantalum oxalate solution with a concentration of 0.089 mol/liter (solution 1) and 100 ml of aqueous solution containing 3.49 g of barium nitrate and 1.32 g of zinc nitrate dissolved therein (solution 2) were prepared.

The solution 1 and the solution 2 were successively added dropwise to 800 ml of ethanol, while stirring, and ammonia water was then added dropwise to adjust the pH to 8. Filtration and washing of the precipitates with ethanol were repeated 3 times, followed finally by filtration, and the obtained solid was dried at 120°C for 12 hours and pyrolyzed at 800°C for 2 hours to obtain a powder of $Ba(Zn_{1/3}Ta_{2/3})O_3$.

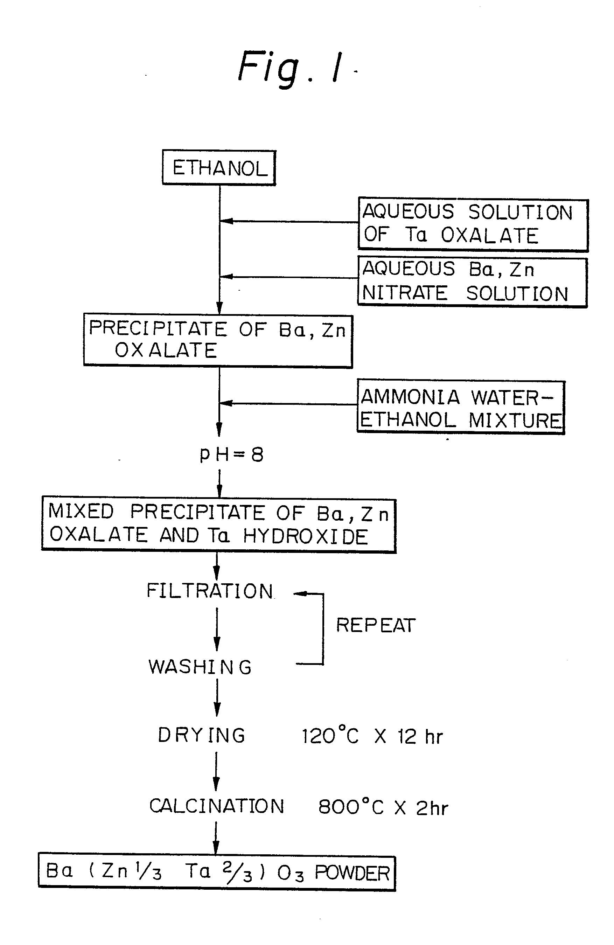

The above-mentioned procedure is shown in Fig. 1.

As a result, a single phase perovskite fine powder having an average particle diameter of 0.8 $\mu$m, determined by a centrifugal sedimentation method, was obtained by a thermal treatment at 800°C for 2 hours, for all of $Ba(Zn_{1/3}Nb_{2/3})O_3$ , $Ba(Zn_{1/3}Ta_{2/3})O_3$ , and $Ba(Mg_{1/3}Ta_{2/3})O_3$.

Example 2

A 100 ml amount of an aqueous niobium oxalate solution with a concentration of 0.31 mol/liter (solution 1) and 100 ml of an aqueous solution containing 4.23 g of magnesium nitrate and 15.5 g of lead nitrate dissolved therein (solution 2) were prepared.

The solution 1 and the solution 2 were successively added dropwise to 800 ml of ethanol, while stirring, and ammonia water was then added dropwise to adjust the pH to 8. Filtration and washing of the precipitates with ethanol were repeated 3 times, followed finally by filtration, and the obtained solid was dried at 120°C for 12 hours and pyrolyzed at 800°C for 2 hours to obtain a PMN powder.

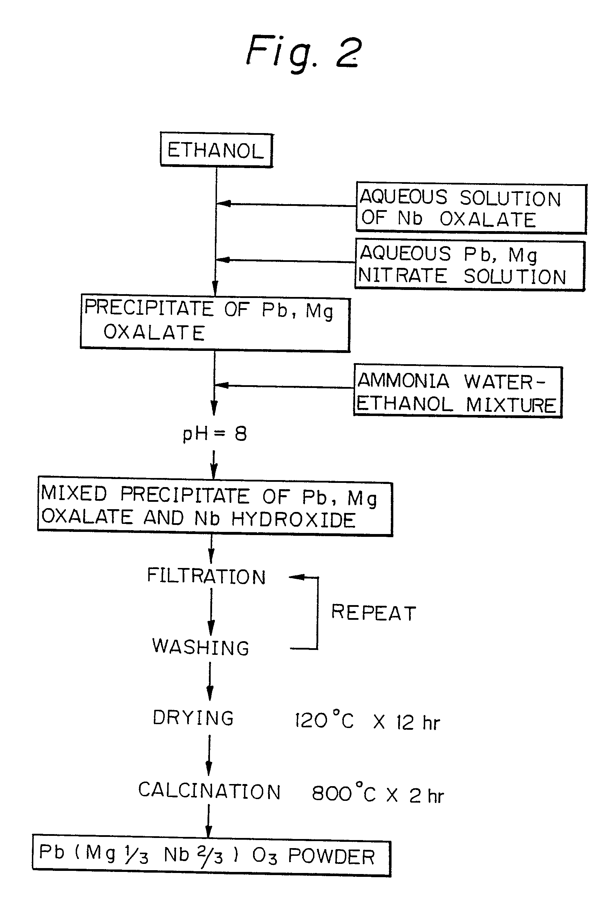

The above-mentioned procedure is shown in Fig. 2.

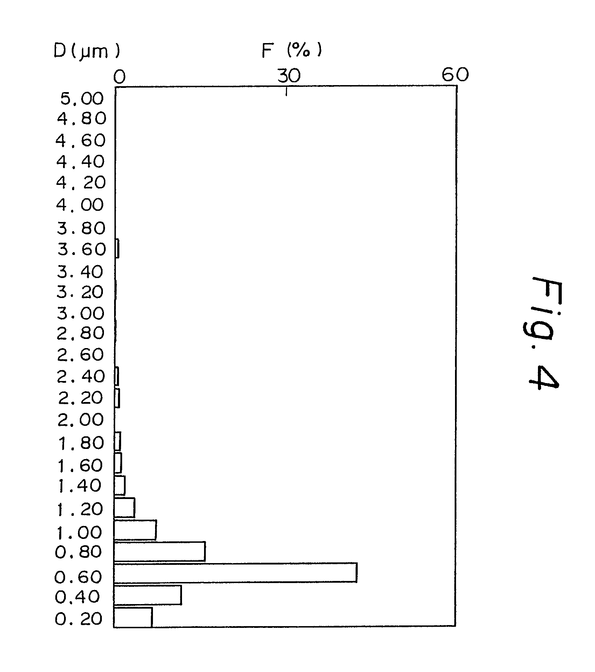

The resultant PMN was a single phase perovskite and the particle size distribution thereof, determined by a centrifugal sedimentation method, was as shown in Fig. 4. The average particle diameter was 0.7 $\mu$m and the standard deviation thereof was 0.8 $\mu$m. The particles were spherically shaped, as shown in Fig. 5.

Example 3

A 100 ml amount of an aqueous niobium oxalate solution with a concentration of 0.31 mol/liter (solution 1) and 100 ml of an aqueous solution containing 4.23 g of magnesium nitrate and 15.5 g of lead nitrate dissolved therein (solution 2) were prepared.

The solution 2 was added dropwise to, 800 ml of ethanol containing 9 g of oxalic acid, while stirring, and after ammonia water was added dropwise to adjust the pH to 8, the solution I was dropwise added thereto while maintaining the pH to 8. Filtration and washing of the precipitates with ethanol were repeated 3 times, followed finally by filtration, and the obtained solid was dried at 120°C for 12 hours and pyrolyzed at 850°C for 2 hours to obtain a PMN powder.

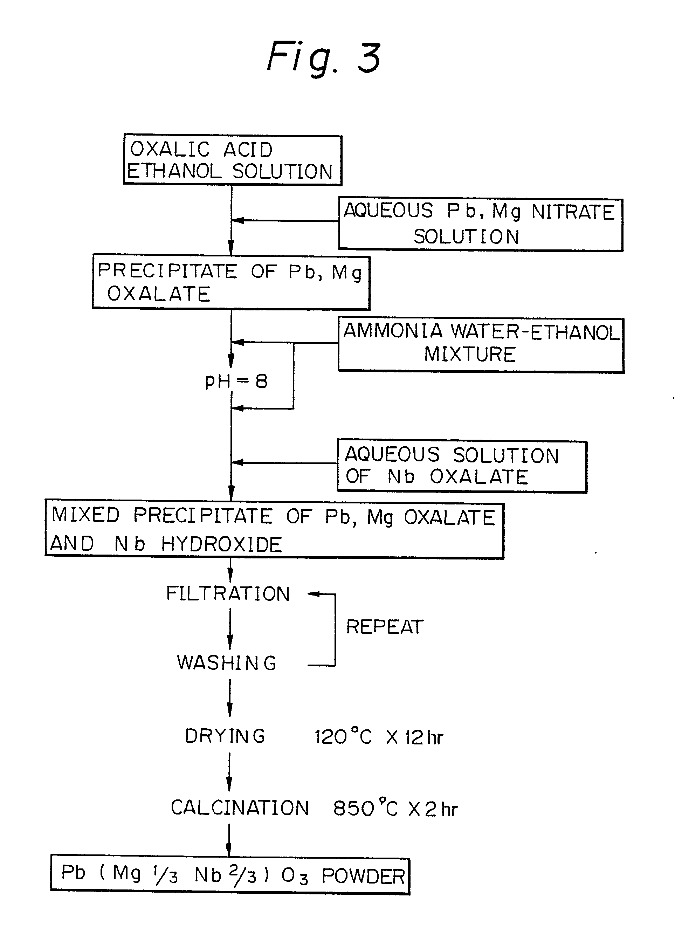

The above-mentioned procedure is shown in Fig. 3.

The resultant PMN was a single phase perovskite and the average particle diameter, determined by a centrifugal sedimentation method, was 0.8 $\mu$m, and the desired quality particles having spherical shape were obtained as in Example 2.

Example 4

A 66.96 g, 4.23 g, and 26.58 g amount of a powder of having a high degree of purity PbO, MgO, and Nb₂O₅ , respectively were weighed and then mixed for 24 hours in a ball mill, followed by a thermally treatment at a temperature of 870 ° C for 4 hours. The particle size and pyrochlore phase ratio obtained by a ratio of the main peaks in the X-ray diffraction pattern of the resultant powder were determined, and the results thereof are compared, as shown in Table 1, with those of Examples 2 and 3.

The pyrochlore phase ratio was determined as follows:

Ipyro/(Iper + Ipyro)

where Iper denotes main peak intensity of the perovskite phase, and Ipyro denotes main peak intensity of the pyrochlore phase. As shown in Table 1, it can be understood that, according to the present invention, the perovskite phase having a very small pyrochlore phase was obtained by a thermal treatment at a lower temperature and for a shorter time.

### Table 1: Comparison of Present Invention with Solid Phase Reaction Method

|  | Example 2 | Example 3 | Solid Phase Reaction Method |
|---|---|---|---|
| Heat Treatment (Calcination) Temp. | 800°C x 2 hr | 850°C x 2 hr | 870°C x 4 hr |
| Pyrochlore Phase Ratio* | 3% | 8% | 27% |
| Average Particle Size | 0.7 μm | 0.8 μm | 2.5 μm |

\* Determined by Ipyro/(Iper + Ipryo)

Iper: Main peak intensity of perovskite phase

Ipyro: Main peak intensity of pyrochlore phase

Example 5

The PMN type actuator material, 0.45 Pb (Mg$_{1/3}$Nb$_{2/3}$)O₃ - 0.36 Pb TiO₃ - 0.19 Ba(Zn$_{1/3}$Nb$_{2/3}$)O₃ was synthesized in the same manner as of Example 1, except that 1 liter of a 0.31 mol/l aqueous niobium oxalate solution was used as the solution 1 of Example 1 and that a mixture of 670 ml of an aqueous solution containing 196.4 g of lead nitrate, 36.5 g of barium nitrate 29.7 g of magnesium nitrate, and 14.6 g of zinc nitrate with 330 ml of a 0.79 mol/l aqueous titanyl nitrate solution was used as the solution 2 of Example 1. The resultant powder was casted in sheets, and after an Ag internal electrode was printed on each ceramic sheet, a laminate having 30 layers thereof was produced. The laminate of body was sintered at a temperature of 900 ° C for 30 minutes, to obtain a multilayer electrostrictive actuator.

On the other hand, an electrostrictive actuator was prepared from PMN powder obtained by a conventional method by printing a Pt internal electrode, producing a laminated body having 30 layers thereof, and sintering at a temperature of 1200 ° C for 30 minutes.

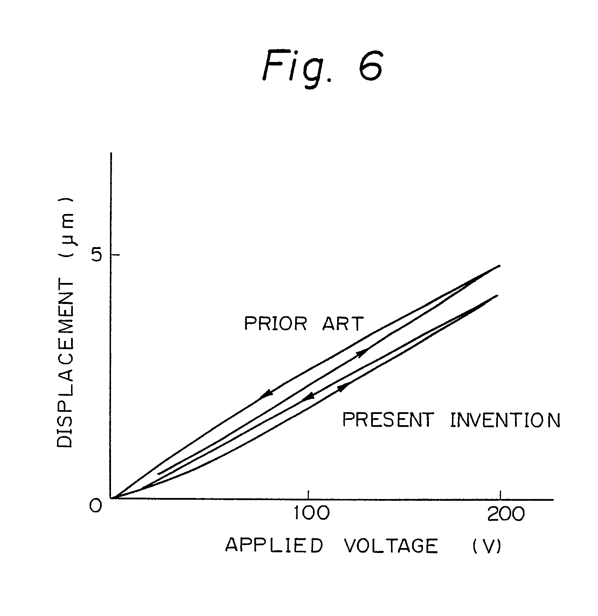

The displacement characteristics of both actuators were compared, and the results are shown in Fig. 6. As is clear from the results shown in Fig. 6, the hysteresis of the actuator according to the present invention is remarkably smaller than that of the conventional actuator. That is, the hysteresis of the conventional actuator is 9.7%, whereas that of the present actuator is reduced to 4.8% and the temperature stability was about 1.0% per 1˚C in both actuators. Further, the cost of production the electrode can be decreased to one-fifth or less by using a less-expensive silver as an electrode material, according to the present invention.

### Example 6

The PMN-based dielectirc material, $0.95\ Pb\ (Mg_{1/3}Nb_{2/3})O_3 \cdot 0.05\ Pb\ TiO_3$ was synthesized in the same manner as in Example 1, except that 1 liter of a 0.31 mol/l aqueous niobium oxalate solution was used as the solution 1 of Example 1 and that a mixture of 969 ml of an aqueous solution containing 162.3 g of lead nitrate, 42.3 g of magnesium nitrate, with 31 ml of a 0.79 mol/l aqueous titanyl nitrate solution was used as the solution 2 of Example 1. The resultant powder was casted in sheets, and after an Ag internal electrode was printed on each ceramic sheet, a laminated body having 30 layers thereof was produced. The laminate was sintered at a temperature of 900˚C for 30 minutes to obtain a multilayer ceramic capacitor. As the present powder was used as a starting material, the thickness of the ceramic dielectric layer was reduced to about 10 $\mu$m and, as a result, a larger capacitance (i.e., 1.2 $\mu$F) was obtained, even in a small element having a size of 2 x 2 x 0.5 mm.

On the other hand, a multilayer ceramic capacitor was produced, in the same manner, by using a PMN powder produced by a conventional method. But, since the particle size was large, the thickness of the ceramic dielectric layer could be reduced only to about 30 $\mu$m. The capacitance thereof was 0.37 $\mu$F for the element size of 2 x 2 x 1 mm.

### Claims

1. A method of synthesizing piezoelectric and dielectric ceramics powder, which comprises mixing an aqueous oxalate solution of a group Va element of the periodic table, a solution containing at least one ion selected from the group consisting of ions of Pb, Bi, Ba, Sr, Ca, and rare earth elements (hereinafter "A" element) and a solution containing at least one ion selected from the group consisting of ions of Mg, Cr, Mn, Fe, Co, Ni, Cu, Zn, Ti, Zr, and Hf (hereinafter "B" element) with an alcohol to form precipitates of oxalates of "A" and "B" elements, adjusting a pH of said solution to 3 or more to form hydroxides of the group Va element of the periodic table in said oxalate precipitates, and mixing, filtering, washing, drying, and pyrolyzing the mixture comprising said oxalates of "A" and "B" elements and hydroxides of the group Va element of the periodic table, whereby a perovskite type oxide powder containing the group Va element is synthesized.

2. A method of synthesizing a piezoelectric and dielectric ceramics powder, which comprises mixing a solution containing at least one ion selected from the group consisting of ions of elements of Pb, Bi, Ba, Sr, Ca or rare earth elements (hereinafter "A" element) and at least one ion selected from the group consisting of elements of Mg, Cr, Zn, Mn, Fe, Co, Ni, Cu, Hf, Ti or Zr (hereinafter "B" element) with an alcoholic solution of oxalic acid to form precipitates of oxalates of the "A" and "B" elements, adjusting the pH of said solution to 3 or higher, mixing a solution containing ions of a group Va element of the periodic table with said solution, while precipitating hydroxides of a group Va element of the periodic table, and mixing, filtering, washing, drying and pyrolyzing the mixture comprising said oxalates of "A" and "B" elements and hydroxides of the group Va element of the periodic table, whereby a perovskite type oxide powder containing the group Va element is synthesized.

3. A readily sinterable powder of $Pb(Mg_{1/3}Nb_{2/3})O_3$ comprising a single phase perovskite having particles which are substantially spherical in shape and having an average particle size, and a standard deviation of both being 1 $\mu$m or less, which is sinterable at a temperature of 1000˚C or lower.

4. A readily sinterable powder for a multilayer element of $Pb(Mg_{1/3}Nb_{2/3})O_3$-based oxides in which one or two of $PbTiO_3$ and $Ba(Zn_{1/3}Nb_{2/3})O_3$ are added to the $Pb(Mg_{1/3}Nb_{2/3})O_3$ of claim 3 in an amount of 5 to 50 mol% of the total amount of the powder.

5. A method of producing the readily sinterable powder for a multilayer element of claim 3, wherein the powder is produced by a method of synthesizing a powder of the perovskite type oxide containing $Pb(Mg_{1/3}Nb_{2/3})O_3$ or $Pb(Mg_{1/3}Nb_{2/3})O_3$, as the main component, and optionally one or both of $PbTiO_3$ and $Ba(Zn_{1/3}Nb_{2/3})O_3$ by mixing an aqueous oxalate solution of Nb, a solution containing a Pb ion or a Pb ion and a Ba ion (hereinafter "A" element), a solution containing an Mg ion or an Mg ion and one or both of a Ti ion and a Zn ion (hereinafter "B" element), with an alcohol to form precipitates of oxalates of "A" elements and "B" elements, adjusting the pH of said solution to 3 or more to form hydroxides of Nb in the precipitates of oxalates of said "A" element and "B" element, and mixing, filtering, washing, drying, and pyrolyzing the mixture comprising oxalates of said "A" and "B" elements and hydroxides of Nb.

6. A method of producing the readily sinterable powder for a multilayer element of claim 4, wherein the powder is produced by a method of synthesizing a powder of the perovskite type oxide containing Pb-$(Mg_{1/3}Nb_{2/3})O_3$ or $Pb(Mg_{1/3}Nb_{2/3})O_3$, as the main component, and optionally one or both of $PbTiO_3$ and Ba-$(Zn_{1/3}Nb_{2/3})O_3$ by mixing an aqueous oxalate solution of Nb, a solution containing a Pb ion or a Pb ion and a Ba ion (hereinafter "A" element), a solution containing an Mg ion or an Mg ion and one or both of a Ti ion and a Zn ion (hereinafter "B" element), with an alcohol to form precipitates of oxalates of "A" elements and "B" elements, adjusting the pH of said solution to 3 or more to form hydroxides of Nb in the precipitates of oxalates of said "A" element and "B" element, and mixing, filtering, washing, drying, and pyrolyzing the mixture comprising oxalates of said "A" and "B" elements and hydroxides of Nb.

7. A multilayer electrostrictive actuator produced by laminating a plurality of ceramic green sheets having an internal electrode material printed thereon, said ceramic green sheets comprising the readily sinterable powder of $Pb(Mg_{1/3}Nb_{2/3})O_3$ of claim 3, or $Pb(Mg_{1/3}Nb_{2/3})O_3$ containing 5 to 50 mol% of one or two of $PbTiO_3$ and $Ba(Zn_{1/3}Nb_{2/3})O_3$ added thereto, of claim 4, followed by sintering.

8. A multilayer ceramic capacitor produced by laminating a plurality of ceramic green sheets having an internal electrode material printed thereon, said ceramic green sheets comprising the readily sinterable powder of $Pb(Mg_{1/3}Nb_{2/3})O_3$ of claim 3, or $Pb(Mg_{1/3}Nb_{2/3})O_3$ containing 5 to 50 mol% of one or two of $PbTiO_3$ and $Ba(Zn_{1/3}Nb_{2/3})O_3$ added thereto, of claim 4, followed by sintering.

# Fig. 1

```
                    ┌─────────────┐
                    │   ETHANOL   │
                    └──────┬──────┘
                           │          ┌──────────────────────┐
                           │◄─────────│ AQUEOUS SOLUTION      │
                           │          │ OF Ta OXALATE         │
                           │          └──────────────────────┘
                           │          ┌──────────────────────┐
                           │◄─────────│ AQUEOUS Ba,Zn         │
                           │          │ NITRATE SOLUTION      │
                           ▼          └──────────────────────┘
                ┌──────────────────────┐
                │ PRECIPITATE OF Ba, Zn │
                │ OXALATE               │
                └──────────┬───────────┘
                           │          ┌──────────────────────┐
                           │◄─────────│ AMMONIA WATER-        │
                           │          │ ETHANOL MIXTURE       │
                           ▼          └──────────────────────┘
                        pH = 8
                           │
                           ▼
          ┌─────────────────────────────────┐
          │ MIXED PRECIPITATE OF Ba, Zn      │
          │ OXALATE AND Ta HYDROXIDE         │
          └────────────────┬────────────────┘
                           ▼
                      FILTRATION ◄──────┐
                           │            │ REPEAT
                           ▼            │
                       WASHING ─────────┘
                           │
                           ▼
                       DRYING      120°C X 12 hr
                           │
                           ▼
                      CALCINATION   800°C X 2hr
                           │
                           ▼
          ┌──────────────────────────────────┐
          │ Ba (Zn 1/3  Ta 2/3) O3 POWDER    │
          └──────────────────────────────────┘
```

# Fig. 2

```
        ┌──────────┐
        │ ETHANOL  │
        └──────────┘
             │                    ┌──────────────────────┐
             │ ◄──────────────────│ AQUEOUS SOLUTION     │
             │                    │ OF Nb OXALATE        │
             │                    └──────────────────────┘
             │                    ┌──────────────────────┐
             │ ◄──────────────────│ AQUEOUS Pb, Mg       │
             ▼                    │ NITRATE SOLUTION     │
   ┌──────────────────────┐       └──────────────────────┘
   │ PRECIPITATE OF Pb, Mg│
   │ OXALATE              │
   └──────────────────────┘
             │                    ┌──────────────────────┐
             │ ◄──────────────────│ AMMONIA WATER-       │
             ▼                    │ ETHANOL MIXTURE      │
          pH = 8                  └──────────────────────┘
             │
             ▼
   ┌──────────────────────────────┐
   │ MIXED PRECIPITATE OF Pb, Mg  │
   │ OXALATE AND Nb HYDROXIDE     │
   └──────────────────────────────┘
             │
             ▼
        FILTRATION ◄──────┐
             │            │ REPEAT
             ▼            │
         WASHING ─────────┘
             │
             ▼
         DRYING      120°C X 12 hr
             │
             ▼
      CALCINATION    800°C X 2 hr
             │
             ▼
   ┌──────────────────────────────────────┐
   │ Pb ( Mg 1/3 Nb 2/3 ) O₃ POWDER       │
   └──────────────────────────────────────┘
```

$Pb(Mg_{1/3}Nb_{2/3})O_3$ POWDER

# Fig. 3

```
┌─────────────────────┐
│ OXALIC ACID         │
│ ETHANOL SOLUTION    │
└─────────────────────┘
          │              ┌─────────────────────────┐
          │◄─────────────│ AQUEOUS Pb, Mg NITRATE  │
          │              │        SOLUTION          │
          ▼              └─────────────────────────┘
┌─────────────────────┐
│ PRECIPITATE OF Pb, Mg│
│  OXALATE            │
└─────────────────────┘
          │              ┌─────────────────────────┐
          │◄─────────────│ AMMONIA WATER-ETHANOL   │
       pH = 8           │        MIXTURE           │
          │◄─────────────└─────────────────────────┘
          │
          │              ┌─────────────────────────┐
          │◄─────────────│ AQUEOUS SOLUTION        │
          ▼              │ OF Nb OXALATE           │
┌──────────────────────────────┐  └──────────────┘
│ MIXED PRECIPITATE OF Pb, Mg OXALATE│
│ AND  Nb HYDROXIDE             │
└──────────────────────────────┘
          │
          ▼
     FILTRATION ◄────────┐
          │              │ REPEAT
          ▼              │
     WASHING ────────────┘
          │
          ▼
     DRYING     120°C X 12 hr
          │
          ▼
     CALCINATION   850°C X 2 hr
          │
          ▼
┌──────────────────────────────┐
│ Pb ( Mg 1/3 Nb 2/3 ) O3 POWDER│
└──────────────────────────────┘
```

# Fig. 4

## Fig. 5

1 μm

# Fig. 6